# EUROPÄISCHE PATENTSCHRIFT

(11) **EP 0 988 696 B1**
(45) Veröffentlichungstag und Bekanntmachung des Hinweises auf die Patenterteilung: **04.09.2002**
(21) Anmeldenummer: 98934853.7
(22) Anmeldetag: 03.06.1998
(51) Int. Cl.: H03H 9/64

(54) **TRANSVERSALMODENRESONATORFILTER**
TRANSVERSAL-MODE RESONATOR FILTER
FILTRE DE RESONATEUR A MODE TRANSVERSAL

(30) Priorität: 09.06.1997 DE 19724255
(43) Veröffentlichungstag der Anmeldung: 29.03.2000
(73) Patentinhaber: EPCOS AG, 81541 München (DE)
(72) Erfinder: BAIER, Thomas, D-81827 München (DE); BAUERNSCHMITT, Ulrich, D-85748 Garching (DE)
(74) Vertreter: Epping, Wilhelm, Dipl.-Ing.
(86) Internationale Anmeldenummer: DE9801505
(87) Internationale Veröffentlichungsnummer: WO98057427

(56) Entgegenhaltungen:
- EP-A- 0 056 690
- EP-A- 0 772 293
- EP-A- 0 786 681
- DE-A- 4 431 612

## Beschreibung

Die vorliegende Erfindung betrifft ein transversalmodengekoppeltes Oberflächenwellen-Resonatorfilter, im folgenden auch Transversalmodenresonatorfilter genannt, nach dem Oberbegriff des Patentanspruches 1.

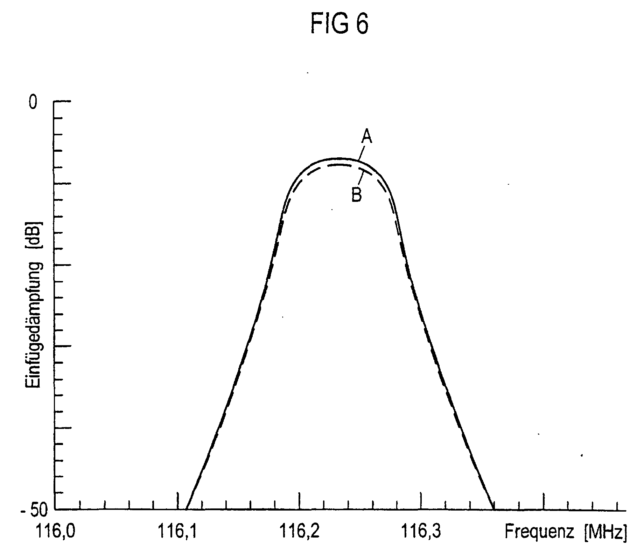

Resonatorfilter sind beispielsweise aus "1992, Ultrasonics Symposium", Seiten 39 bis 43 bekannt. Ihr prinzipieller Aufbau ist schematisch in Fig. 5 dargestellt. Das Resonatorfilter enthält zwei Resonatoren RES, die jeweils einen Interdigitalwandler W9 bzw. W10 mit uniformer Normalfingerstruktur sowie jeweils zwei auf entgegengesetzten Seiten der Interdigitalwandler W9 und W10 angeordnete kurz geschlossene Reflektoren R1, R1 bzw. R3, R3 aufweisen. Die Reflektoren sind über eine gemeinsame Sammelschiene 2 elektrisch und akustisch miteinander gekoppelt, die als Masseschiene wirkt und über Masseanschlüsse elektrisch zugänglich ist.

Beim Filter nach Fig. 5 ist der Interdigitalwandler W9 dem Filtereingang und der Interdigitalwandler W10 dem Filterausgang zugeordnet. Sämtliche bisher realisierten Transversalmodenresonatorfilter - so auch dieses bekannte Filter - besitzen identische Ein- und Ausgangswandler und damit identische Ein- und Ausgangsimpedanzen.

Aus der EP 0 772 293 A1 ist ein transversalmodengekoppeltes Oberflächenwellen-Resonatorfilter bekannt, welches aus zwei akustisch gekoppelten Spuren aufgebaut ist, wobei ein Wandler durch einen Split-Wandler ersetzt ist, der eine höhere Impedanz als ein Normalfingerwandler aufweist.

Zur möglichst problemlosen Anpassung eines Oberflächenwellenfilters an seine Schaltungsumgebung muß jedoch der Realteil der Filtereingangs- und der Filterausgangsimpedanz jeweils mit der Impedanz der dem Filtereingang vorangehenden bzw. dem Filterausgang nachfolgenden Stufe identisch sein. In den seltensten Fällen ist diese Forderung erfüllt, weshalb häufig aufwendige Schaltungsmaßnahmen notwendig werden.

Die vorliegende Erfindung hat sich die Aufgabe gestellt, diesen, den bekannten Filtern anhaftenden Nachteil zu beheben, d.h. einen Weg aufzuzeigen, durch den Filter mit entsprechend angepaßten unterschiedlichen Ein- und Ausgangsimpedanzen geschaffen werden können.

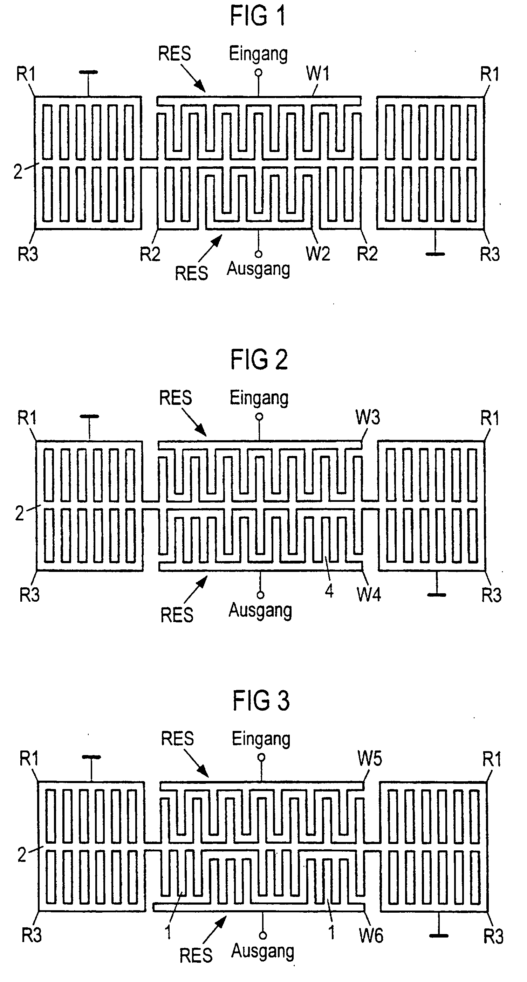

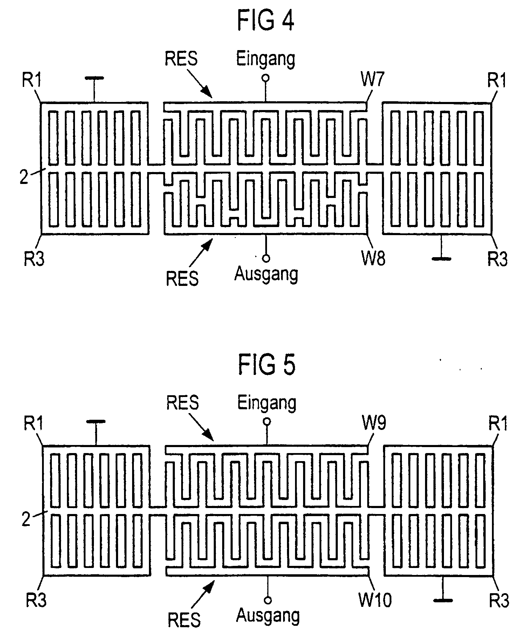

Zur Lösung dieser Aufgabe sieht die Erfindung bei einem Transversalmodenresonatorfilter nach dem Oberbegriff vor, daß die Impedanz der Ein- oder Ausgangswandler durch Reduzierung der ursprünglichen aktiven Fingerüberlappung gegenüber einer uniformen Normalfingerstruktur erhöht ist durch eine der Maßnahmen a) bis c):
a) die Wandlerlänge eines Wandler (W2) ist verkürzt (Fig. 1);
b) die aktive Fingerüberlappung eines Wandlers (W4, W6) ist durch Weglaßwichtung reduziert (Fig. 2, Fig. 3);
c) die aktive Fingerüberlappung eines Wandlers (W8) ist durch Überlappungswichtung reduziert (Fig. 4).

Weitere Merkmale der Erfindung sind den restlichen Unteransprüchen, der Beschreibung und Zeichnung entnehmbar.

Es zeigt jeweils in schematischer Darstellung:
- Fig. 1: bis 4 ein erstes bis viertes Ausführungsbeispiel eines Transversalmodenresonatorfilters nach der Erfindung;
- Fig. 5: das eingangs erläuterte bekannte Filter; und
- Fig. 6: die über der Frequenz aufgetragene Einfügedämpfung für Filter nach Fig. 5 und das Filter gemäß der Erfindung nach Fig. 1.

Gleiche Elemente in den Figuren sind mit gleichen Bezugszeichen bezeichnet.

In den Ausführungen zu den Figuren 1 bis 4 wird, soweit dies bereits das anhand von Fig. 5 erläuterte gleiche Element betrifft, auf eine nochmalige Erläuterung verzichtet.

Das Filter nach Fig. 1 hat einen Eingangswandler W1 mit uniformer Fingerstruktur, d.h. einen sogenannten Normalfingerwandler. Die im Vergleich hierzu reduzierte aktive Fingerüberlappung des Ausgangswandlers W2 und die damit erhöhte Impedanz dieses Wandlers läßt sich - betrachtet in Ausbreitungsrichtung der akustischen Wellen - durch Verkürzung des Ausgangswandlers W2 einstellen.

Der durch die Verkürzung geschaffene Freiraum ist - s. Fig. 1 durch zusätzliche Reflektoren R2, R2 aufgefüllt und damit die Reflektorwirkung verstärkt.

Wie bereits erwähnt wurde und im übrigen auch für die folgenden Ausführungsbeispiele zutrifft, kann je nach Bedarf in gleicher Weise der Eingangswandler strukturiert werden, wobei zur Vermeidung gleicher Ein- und Ausgangsimpedanzen lediglich auf unterschiedliche aktive Fingerstrukturen zu achten ist.

Fig. 6 zeigt die über der Frequenz aufgetragene Einfügedämpfung für das bekannte Transversalmodenresonatorfilter gemäß Fig. 5 - s. die durchgezogene Kurve A -, und für das Filter nach Fig. 1 mit im Vergleich zum Filter nach Fig. 5 auf die halbe Länge gekürztem Ausgangswandler W2 - s. hierzu die gestrichelte Kurve B. Der dabei auftretende Unterschied in der Einfügedämpfung von ca. 1 dB ist auf schaltungsbedingte Verluste im elektrischen Anpassungsnetzwerk zurückzuführen. Die Impedanz des Ausgangswandlers W2 ist um den Faktor 4 höher als die Eingangsimpedanz.

Beim Filter nach Fig. 2 wird bei gleichfalls uniformer Fingerstruktur des Eingangswandlers W 3 die Impedanz des Ausgangswandlers W 4 durch Weglaßwichtung des Ausgangswandlers erzielt. Die Weglaßwichtung sieht dabei Blindfinger 4, d.h. überlappungsfreie und somit elektrisch und akustisch weitgehend inaktive Finger vor.

Eine weitere Möglichkeit der Weglaßwichtung zeigt das Filter nach Fig. 3, dessen Eingangswandler mit Normalfingerstruktur mit W5 und dessen Ausgangswandler mit W6 bezeichnet ist. Das Maß der aktiven Fingerüberlappung des Ausgangswandlers W6 wird hier durch die Anordnung einer entsprechenden Anzahl von Blindfingern 1 gesteuert.

Beim Ausführungsbeispiel eines Filters nach Fig. 4, das ebenfalls einen Eingangswandler W7 mit Normalfingerstruktur besitzt, sieht die Erfindung zur Erhöhung der Impedanz des Ausgangswandlers W8 eine Überlappungswichtung vor.

Die Erfindung ist, wie bereits erwähnt wurde, auch auf die Eingangswandler anwendbar. Im Falle ihrer gleichzeitigen Anwendung auf beide Wandler ist, falls erwünscht, zur Vermeidung gleicher Ein- und Ausgangsimpedanzen lediglich auf eine unterschiedliche Strukturänderung zu achten.

Die Erfindung ist nicht beschränkt auf Transversalmodenresonatorfilter mit nur einem Ein- und Ausgangswandler. Es können auch mehrere Filter dieser Art seriell oder parallel geschaltet sein.

Die Filtergestaltung gemäß den Figuren 2, 4 ist im übrigen geeignet, zusätzlich die Nahselektion des Filters zu verbessern.

## Patentansprüche

1. Transversalmodenresonatorfilter mit zwei identischen, in zwei Spuren angeordneten, akustisch gekoppelten und zwischen Reflektoren angeordneten Ein- und Ausgangswandlern mit Normalfingerstruktur, bei dem die Impedanz der Ein- oder Ausgangswandler erhöht ist,
**dadurch gekennzeichnet,**
**daß** die Impedanz der Ein- oder Ausgangswandler durch Reduzierung der ursprünglichen aktiven Fingerüberlappung gegenüber einer uniformen Normalfingerstruktur erhöht ist durch eine der Maßnahmen a) bis c) :
a) die Wandlerlänge eines Wandler (W2-Fig.1) ist verkürzt ;
b) die aktive Fingerüberlappung eines Wandlers (W4-Fig. 2 ; W6-Fig. 3) ist durch Weglaßwichtung reduziert ;
c) die aktive Fingerüberlappung eines Wandlers ist (W8-Fig. 4) ist durch Überlappungswichtung reduziert.

2. Filter nach Anspruch 1,
bei dem entsprechend der Maßnahme a) der durch die verkürzte Wandlerlänge gebildete Freiraum durch zusätzliche Reflektoren (R2, R2-Fig. 1) aufgefüllt ist.

3. Filter nach Anspruch 1, bei dem die Weglaßwichtung teils durch Blindfinger (1-Fig.3) realisiert ist .

4. Filter nach einem der Ansprüche 1 bis 3,
bei dem mehrere Transversalmodenresonatorfilter seriell geschaltet sind.

5. Filter nach einem der Ansprüche 1 bis 3,
bei dem mehrere Transversalmodenresonatorfilter parallel geschaltet sind.

## Claims

1. Transverse-mode resonator filter having two identical input and output converters, which are arranged in two tracks, are acoustically coupled, are arranged between reflectors and have a normal finger structure, in which the impedance of the input or output converter is increased,
**characterized**
**in that** the impedance of the input or output converter is increased by reducing the original active finger overlap with respect to a uniform normal finger structure, by one of the measures a) to c):
a) the converter length of one converter (W2 - Figure 1) is shortened;
b) the active finger overlap of one converter (W4 - Figure 2; W6 - Figure 3) is reduced by omission weighting;
c) the active finger overlap of one converter (W8 - Figure 4) is reduced by overlap weighting.

2. Filter according to Claim 1, in which, corresponding to measure a) the free space formed by the shortened converter length is filled by additional reflectors (R2, R2 - Figure 1).

3. Filter according to Claim 1, in which the omission weighting is partially provided by blind fingers (1 - Figure 3).

4. Filter according to one of Claims 1 to 3, in which a plurality of transverse-mode resonator filters are connected in series.

5. Filter according to one of Claims 1 to 3, in which a plurality of transverse-mode resonator filters are connected in parallel.

## Revendications

1. Filtre de résonateur à mode transversal, ayant deux convertisseurs d'entrée et de sortie à structure de doigts normale, identiques, disposés suivant deux pistes couplées acoustiquement et interposés entre des réflecteurs, dans lequel l'impédance du convertisseur d'entrée ou du convertisseur de sortie est augmentée,
**caractérisé**
**en ce que** l'impédance du convertisseur d'entrée ou du convertisseur de sortie est augmentée, par rapport à une structure digitée normale uniforme, par réduction du chevauchement actif des doigts d'origine, par l'une des mesures a) à c) :
a) la longueur d'un transducteur (W2 - figure 1) est diminuée ;
b) le chevauchement actif des doigts d'un convertisseur (W4 - figure 2 ; W6 - figure 3) est réduit par pondération d'omission ;
c) le chevauchement actif des doigts d'un convertisseur (W8 - figure 4) est réduit par pondération de chevauchement.

2. Filtre suivant la revendication 1, dans lequel conformément à la mesure a), l'espace libre formé par la longueur diminuée du convertisseur est empli par des réflecteurs (R2, R2 - figure 1) supplémentaires.

3. Filtre suivant la revendication 1, dans lequel la pondération d'omission est réalisée en partie par des doigts (1 - figure 3) aveugles.

4. Filtre suivant l'une des revendications 1 à 3, dans lequel plusieurs filtres de résonateurs à mode transversal sont montés en série.

5. Filtre suivant l'une des revendications 1 à 3, dans lequel plusieurs filtres de résonateurs à mode transversal sont montés en parallèle.
